# FASCICULE DE BREVET EUROPEEN

(11) **EP 0 581 703 B1**
(45) Date de publication et mention de la délivrance du brevet: **16.10.1996**
(21) Numéro de dépôt: 93420322.5
(22) Date de dépôt: 27.07.1993
(51) Int. Cl.: H01L 21/66, G01R 31/28

(54) **Procédé de test de la résistance par carré de couches diffusées**
Verfahren zur Prüfung des Schichtwiderstandes einer Diffusionsschicht
Method for testing sheet resistivity of diffused layers

(30) Priorité: 30.07.1992 FR 9209797
(43) Date de publication de la demande: 02.02.1994
(73) Titulaire: SGS-THOMSON MICROELECTRONICS S.A., F-94250 Gentilly (FR)
(72) Inventeur: Barthez, Jean, F-38120 Saint Egreve (FR)
(74) Mandataire: de Beaumont, Michel

(56) Documents cités:
- US-A- 4 440 799
- US-A- 4 706 015
- SOLID STATE TECHNOLOGY vol. 26, no. 8 , Aoüt 1983 , WASHINGTON US pages 159 - 167 GRUBER 'ION IMPLANT TESTING...'
- SOLID STATE TECHNOLOGY vol. 27, no. 12 , Décembre 1984 , WASHINGTON US pages 125 - 132 BRENNAN & DICKEY 'DETERMINATION OF DIFFUSION CHARACTERISTICS...'

## Description

La présente invention conoerne la fabrication des composants à semiconducteurs, et en particulier des circuits intégrés.

La fabrication de tels composants implique l'utilisation d'une plaquette de matériau semiconducteur, couramment du silicium, mais aussi par exemple de l'arséniure de gallium, dans laquelle on réalise diverses étapes successives de masquage et de dopage pour obtenir diverses régions de type de conductivité N ou P.

Ces processus sont extrêmement délicats et sujets à variation en fonction de nombreux paramètres. En conséquence, il importe lors d'une fabrication de prévoir une vérification des caractéristiques physiques de chaque région N ou P formée pour détecter une éventuelle dérive du procédé de fabrication.

En ce qui concerne les étapes de dopage, celles-ci comprennent généralement une étape d'implantation et/ou de prédiffusion suivie d'une étape de diffusion dans un four. Cette étape de diffusion est réalisée alors qu'un grand nombre de plaquettes, par exemple 200, sont simultanément placées dans le four dans des nacelles comprenant de 25 à 50 plaquettes. Pour effectuer le contrôle, en même temps que les plaquettes de composants sur lesquelles les zones occupées par les différentes couches sont convenablement localisées, on place dans le four de diffusion des plaquettes témoin ayant subi le même traitement initial. Une telle méthode de contrôle est décrite dans Solid State Technology, vol. 26, no. 8, août 1983, pages 159-167. On mesure alors par la méthode classique des quatre pointes (voir L.B. Valdes "Resistivity Measurement on Germanium for Transistors" Proc. IRE, fev. 1954, 420-427) la résistance de couche appelée aussi résistance superficielle ou résistance par carré (souvent désignée par l'appellation anglo-saxone "sheet resistivity"). Cette résistance est égale à la résistivité moyenne de la couche divisée par son épaisseur et s'exprime en ohms par carré.

Le dispositif de mesure classique comporte une tête à quatre pointes alignées dont la distance peut être quelconque mais est le plus souvent égale à 1/2 Π cm soit 1,59 mm dans les dispositifs commerciaux, ce qui simplifie certaines expressions mathématiques. Pour la mesure, on injecte un courant I entre deux pointes (en général les deux pointes extrêmes) et on mesure la tension V entre les deux autres pointes. La résistance par carré est alors égale à KV/I où K est un coefficient qui dépend de la forme de l'échantillon. Dans le cas où l'échantillon est une surface plane infinie et où le courant est injecté par les deux pointes extrêmes, on a classiquement K = Π/Ln2 = 4,53. Ce cas correspond avec une bonne approximation au cas où la mesure est faite au centre d'une plaquette puisqu'une plaquette d'un diamètre de 100 mm peut être considérée comme un plan infini devant l'espacement de 1,59 mm entre les pointes. Quand on effectue la mesure près des bords de la plaquette, il faut calculer et appliquer des coefficients de correction appropriés (voir David S. Perloff - Four Point Probe Correction Factors for Use in Measuring Large Diameter Doped Semiconductor Wafers - J.E.C.S. - Novembre 1976).

Les équipements classiques comportant une table à déplacement xy couplée à un ordinateur et à un appareil de mesure permettent d'obtenir une cartographie d'une plaquette témoin et de tracer des courbes des points présentant une même résistance par carré. Ces équipements permettent de connaître avec une grande précision la valeur de la résistance par carré d'une couche diffusée et l'uniformité de ce paramètre. Ils ne sont utilisés que lors de la mise au point d'un processus de fabrication ou pour des contrôles approfondis.

Pour les contrôles de fabrication courants, on se borne en général à faire cinq mesures sur une plaquette, à savoir une mesure au centre de la plaquette et quatre à la périphérie dans quatre quadrants en utilisant des appareils plus ou moins automatisés pour obtenir une mesure automatique, un affichage des résultats, une moyenne des écarts, un déplacement automatique des pointes sur les cinq zones de mesure, avec application des coefficients de correction convenables.

Ces contrôles sont utilisés comme on l'a indiqué précédemment avec des plaquettes témoin dans lesquelles la diffusion est réalisée sur l'ensemble de la surface de la plaquette. Etant donné que, pour la surveillance d'une étape de diffusion d'un lot de plaquettes, on utilise généralement trois plaquettes témoin, une au centre du lot et une vers chacune des extrémités de ce lot, ceci nécessite pour une salle de fabrication dans laquelle chaque fournée comprend 200 plaquettes et dans laquelle on réalise 100 fournées par mois, la prévision de 300 plaquettes témoin. Il en résulte un coût non négligeable surtout si l'on considère que l'on tend actuellement à utiliser des plaquettes ayant des diamètres de plus en plus grands, couramment 100, 150 ou 200 millimètres, et donc que le prix d'une plaquette devient élevé.

Pour réduire cette dépense et cette perte de matière, on a envisagé dans l'art antérieur d'araser la surface d'une plaquette témoin après diffusion et contrôles et de la réutiliser. Toutefois, cette opération est relativement coûteuse et délicate et ne peut être répétée un grand nombre de fois si l'on tient compte du fait que l'épaisseur d'une plaquette de silicium n'est couramment que de 0,3 à 0,5 mm.

Un objet de la présente invention est de prévoir un procédé permettant une réduction du nombre de plaquettes témoin utilisées avec des lots de fabrication successifs.

Un autre objet de la présente invention est de prévoir un tel procédé qui n'implique pas la mise en oeuvre d'appareils nouveaux par rapport à ceux actuellement utilisés.

Pour atteindre ces objets, la présente invention prévoit un procédé de test de la résistance par carré de couches diffusées consistant à associer à chaque lot de plaquettes subissant un traitement de dopage et de diffusion au moins une plaquette témoin soumise au même traitement, cette plaquette témoin étant initialement dopée selon un niveau de dopage nettement plus faible et/ou selon un type de conductivité opposé à celui de la couche à tester ; et à effectuer des mesures sous pointe de résistance de la couche diffusée dans une pluralité de zones de chaque plaquette témoin. Avant chaque opération de dopage et de diffusion, une fenêtre est ouverte dans une couche de masquage revêtant la plaquette témoin dans chacune des zones de mesure de la plaquette témoin de sorte que le dopage/ diffusion n'ait lieu que dans une portion de chaque zone où est ensuite effectuée la mesure.

Selon un mode de réalisation de la présente invention, les zones de mesure comprennent une zone centrale et quatre zones réparties dans quatre quadrants de la plaquette.

Selon un mode de réalisation de la présente invention, les plaquettes sont des plaquettes de silicium et les fenêtres sont ouvertes dans une couche de masquage d'oxyde de silicium formée sur au moins une surface principale de la plaquette témoin.

Ces objets, caractéristiques et avantages ainsi que d'autres de la présente invention seront exposés en détail dans la description suivante de modes de réalisation particuliers faite en relation avec les figures jointes, parmis lesquelles :
les figures 1A et 1B sont respectivement une vue de face et une vue en coupe selon la ligne BB de la figure 1A illustrant un procédé de test classique, et
les figures 2A et 2B sont respectivement une vue de face et une vue en coupe selon la ligne BB de la figure 2A illustrant un procédé de test selon la présente invention.

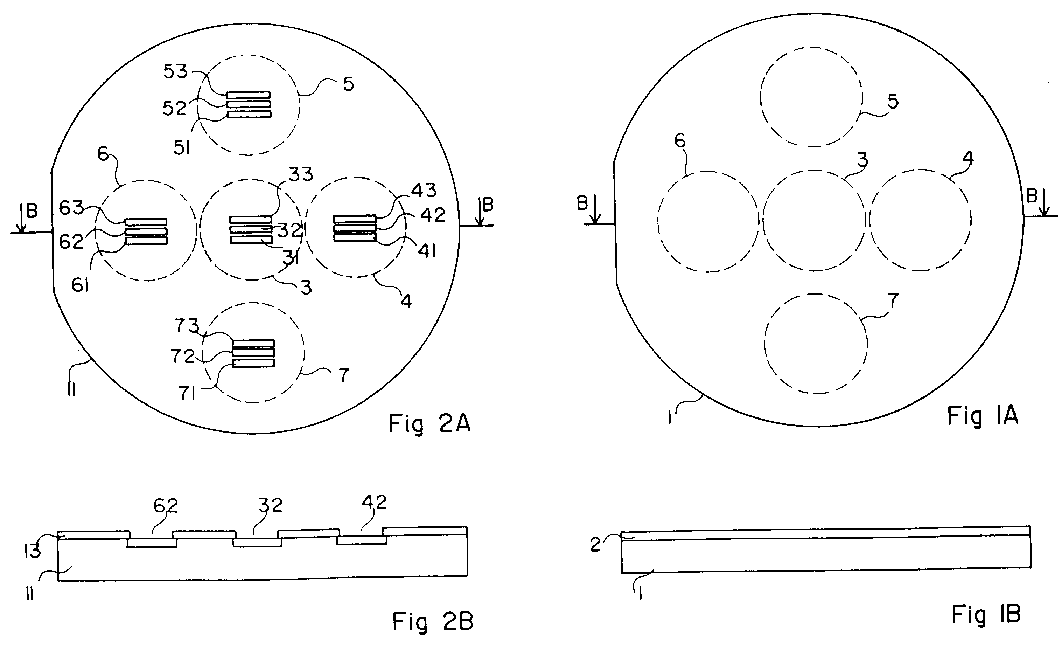

Les figures 1A et 1B sont respectivement une vue de dessus et une vue en coupe d'une plaquette témoin destinée à rappeler le procédé de test utilisé classiquement.

Selon ce procédé, on part d'une plaquette 1 dans laquelle on réalise sur toute une surface (ou les deux surfaces) une diffusion 2 identique à celle que l'on veut tester. De préférence, la plaquette est du type de conductivité opposé à celui de la diffusion dont on veut tester les caractéristiques. On pourrait aussi envisager que la plaquette soit de même type de conductivité que la couche diffusée mais avec un beaucoup plus faible niveau de dopage.

Ensuite, des contrôles sont effectués dans diverses zones de la plaquette, par exemple une zone centrale 3 et des zones latérales 4, 5, 6 et 7.

Les figures 2A et 2B illustrent le procédé selon la présente invention. On part de même d'une plaquette témoin 11. Toutefois, tandis que l'on réalise les opérations d'implantation ou de pré-diffusion dans les plaquettes témoin et dans les plaquettes en cours de fabrication, ces opérations d'implantation et de pré-diffusion ne sont réalisées dans les plaquettes témoin qu'en un ensemble d'emplacements choisis respectivement contenus dans chacune des zones 3, 4, 5, 6 et 7. Par exemple, lors d'une première utilisation d'une plaquette témoin, on revêtira celle-ci d'une couche de masquage, par exemple une couche 13 de SiO₂ dans le cas où la plaquette est une plaquette de silicium, et l'on ouvrira dans cette couche des premières fenêtres 31, 41, 51, 61 et 71 à travers lesquelles sont réalisées les dopages.

Après une opération de contrôle des zones diffusées dans ces premières fenêtres, on ouvrira des fenêtres voisines 32, 42, 52, 62, 72 et ainsi de suite. Cette étape d'ouverture peut, mais cela n'est pas nécessaire, être précédée d'une étape de fermeture des fenêtres précédentes, par exemple, dans le cas de silicium, par dépôt ou croissance d'une nouvelle couche d'oxyde. Dans la représentation de la figure 2A, on n'a illustré que trois fenêtres successives par zone. En pratique, étant donné les écarts classiques entre pointes de test et les surfaces nécessaires, on pourra ouvrir des fenêtres dont chacune a une dimension de sensiblement 1,59 X 10 mm, ce qui laisse sur une plaquette d'un diamètre de 100 millimètres largement la place de réaliser quatre à huit fenêtres successives côte à côte dans chaque zone. L'écart entre les fenêtres est choisi en tenant compte du fait que, à chaque opération de diffusion, une certaine diffusion latérale se produit. De préférence, les fenêtres seront côte à côte, par exemple à 1mm les unes des autres, et l'on utilisera séquentiellement les fenêtres voisines dans l'ordre de la plus proche à la plus éloignée d'une fenêtre extrême pour éviter que des étapes de recuit multiple se produisant dans une zone où a eu lieu une première diffusion n'entraînent que l'étendue latérale de cette diffusion qui devient importante rejoigne la dernière fenêtre à tester.

Des moyens de calcul connus permettent de déterminer la résistance par carré de la zone formée dans chacune des fenêtres avec la même précision que dans le cas où une diffusion pleine plaque a été réalisée.

Ensuite, une fois que toutes les fenêtres que l'on souhaite utiliser l'ont été, on pourra, comme dans le cas des procédés classiques, procéder à un arasement superficiel de la plaquette pour éliminer les régions diffusées et recommencer ensuite l'opération.

Bien entendu, la présente invention est susceptible de nombreuses variantes et modifications qui apparaitront à l'homme de l'art, notamment en ce qui concerne les formes, le nombre et la disposition des fenêtres successives ouvertes dans chacune des zones choisies. A chaque étape de test, au lieu d'utiliser une tête de mesure unique déplacée d'une zone de mesure à l'autre, on pourra utiliser un ensemble de cinq têtes réalisant des mesures simultanees.

## Revendications

1. Procédé de test de la résistance par carré de couches diffusées d'une plaquette de matériau semiconducteur consistant à :
associer à chaque lot de plaquettes de matériau semiconducteur subissant un traitement de dopage et de diffusion au moins une plaquette témoin (11) soumise au même traitement, cette plaquette témoin étant initialement dopée selon un niveau de dopage nettement plus faible et/ou selon un type de conductivité opposé à celui de la couche à tester ;
effectuer des mesures sous pointe de résistance de la couche diffusée dans une pluralité de zones de chaque plaquette témoin ;
caractérisé en ce que, avant chaque opération de dopage et de diffusion, une fenêtre est ouverte dans une couche de masquage revêtant la plaquette témoin dans chacune desdites zones de la plaquette témoin de sorte que le dopage/ diffusion n'ait lieu que dans une portion de ladite zone où est ensuite effectuée ladite mesure.

2. Procédé de test selon la revendication 1, caractérisé en ce qu'il comprend en outre, après les étapes de mesure, l'étape consistant à ouvrir de nouvelles fenêtres voisines dans lesdites zones.

3. Procédé de test selon la revendication 2, caractérisé en ce qu'il comprend en outre l'étape consistant à fermer les fenêtres préalablement formées dans lesdites zones avant d'ouvrir de nouvelles fenêtres voisines dans lesdites zones.

4. Procédé de test selon la revendication 1, caractérisé en ce que lesdites zones comprennent une zone centrale et quatre zones réparties dans quatre quadrants de la plaquette.

5. Procédé de test selon la revendication 1, caractérisé en ce que les plaquettes sont des plaquettes de silicium et en ce que les fenêtres sont ouvertes dans une couche de masquage d'oxyde de silicium formée sur au moins une surface principale de la plaquette témoin.

## Patentansprüche

1. Verfahren zum Prüfen des Schichtwiderstands von diffundierten Schichten eines Wafers aus einem Halbleitermaterial, welches aus den folgenden Schritten besteht:
- Zuordnen zumindest eines Kontrollwafers (11) zu jeder Charge von Wafern aus einem Halbleitermaterial, die einer Dotierungs- und Diffusionsbehandlung unterzogen wird, welcher derselben Behandlung unterzogen wird, wobei dieser Kontrollwafer zu Beginn entsprechend einem deutlich geringeren Dotierungsniveau und/oder entsprechend einem Leitfähigkeitstyp dotiert ist, welcher demjenigen der zu prüfenden Schicht entgegengesetzt ist,
- Messen des Schichtwiderstands der diffundierten Schicht in mehreren Bereichen jedes Kontrollwafers,
dadurch gekennzeichnet, daß vor jedem Dotierungs- und Diffusionsvorgang ein Fenster in einer Maskenschicht, welche den Kontrollwafer bedeckt, in jedem der besagten Bereiche des Kontrollwafers derart geöffnet wird, daß die Dotierung/Diffusion nur in einem Teil des besagten Bereichs stattfindet, wo danach die besagte Messung durchgeführt wird.

2. Prüfverfahren nach Anspruch 1, dadurch gekennzeichnet, daß es weiterhin nach den Meßschritten einen Schritt umfaßt, welcher in dem Öffnen von neuen, benachbarten Fenstern in den besagten Bereichen besteht.

3. Prüfverfahren nach Anspruch 2, dadurch gekennzeichnet, daß es weiterhin einen Schritt umfaßt, der aus dem Schließen der vorher in den besagten Bereichen gebildeten Fenster vor dem Öffnen von neuen, benachbarten Fenstern in den besagten Bereichen besteht.

4. Prüfverfahren nach Anspruch 1, dadurch gekennzeichnet, daß die besagten Bereiche einen zentralen Bereich und vier Bereiche, die auf vier Quadranten des Wafers verteilt sind, umfassen.

5. Prüfverfahren nach Anspruch 1, dadurch gekennzeichnet, daß die Wafer Siliciumwafer sind und daß die Fenster in einer Maskierschicht aus Siliciumoxid geöffnet werden, die auf zumindest einer Hauptfläche des Kontrollwafers ausgebildet ist.

## Claims

1. A method for testing the sheet resistivity of diffused layers of a semiconductive material wafer consisting in:
inserting in each semiconductive material wafer batch, withstanding a doping and diffusion process, at least one reference wafer (11) subject to the same process, said reference wafer being initially doped according to a substantially lower doping level and/or according to a conductivity type opposite to the conductivity type of the layer to be tested;
measuring the sheet resistivity of the diffused layer in a plurality of areas of each reference wafer;
characterized in that, prior to each doping and diffusion step, a window is opened in a masking layer coating the reference layer in each measurement area of said reference wafer so that the doping and diffusion operation is achieved only in a portion of each said area where said measurement is subsequently carried out.

2. The measurement method of claim 1, characterized in that it further comprises, after the measurement steps, the step consisting in opening new adjacent windows in said areas.

3. The measurement method of claim 2, characterized in that it further comprises the step consisting in closing the windows previously formed in said areas prior to opening new adjacent windows in said areas.

4. The measurement method of claim 1, characterized in that said areas include a central area and four areas distributed in four quadrants of the wafer.

5. The measurement method of claim 1, characterized in that said wafers are made of silicon and wherein the windows are opened in a masking silicon oxide layer that is formed on at least one main surface of said reference wafer.
